# EUROPEAN PATENT SPECIFICATION

(11) **EP 0 468 759 B1**
(45) Date of publication and mention of the grant of the patent: **22.09.2004**
(21) Application number: 91306730.2
(22) Date of filing: 24.07.1991
(51) Int. Cl.: H01L 21/20, H01L 21/84, H01L 21/324

(54) **Method for crystallising a non-single crystal semiconductor by heating**
Verfahren zum Kristallisieren eines Nicht-Einkristall Halbleiters mittels Heizen
Méthode de cristallisation d'un semi-conducteur non monocristallin par chauffage

(30) Priority: 24.07.1990 JP 19517390; 28.07.1990 JP 19997990; 28.07.1990 JP 19998090
(43) Date of publication of application: 29.01.1992
(73) Proprietor: SEMICONDUCTOR ENERGY LABORATORY CO., LTD., Atsugi-shi Kanagawa-ken 243-0036 (JP)
(72) Inventor: Zhang, Hongyong Paresu Miyagami 302, Kanagawa-ken, 242 (JP)
(74) Representative: Burke, Steven David

(56) References cited:
- PATENT ABSTRACTS OF JAPAN vol. 8, no. 17 (E-223) 25 January 1984, & JP-A-58 182243 (TOKYO SHIBAURA DENKI K.K.) 25 October 1983,
- EXTENDED ABSTRACTS OF THE 20th. INT. CONF. ON SOLID STATE DEV. AND MATER. 24 August 1988, TOKYO pages 619 - 620; K. NAKAZAWA et al.: "Low temperature Thin Film Transistor fabrication using a polycrystalline Silicon film formed from a fluorinated Silicon film"
- PATENT ABSTRACTS OF JAPAN vol. 14, no. 208 (C-714) 27 April 1990, & JP-A-02 044022 (MATSUSHITA ELECTRIC IND. CO. LTD.) 14 February 1990,
- PATENT ABSTRACTS OF JAPAN vol. 13, no. 47 (P-822) 03 February 1989, & JP-A-63 240524 (ALPS ELECTRIC CO. LTD.) 06 October 1988,
- PATENT ABSTRACTS OF JAPAN vol. 13, no. 490 (E-841) 07 November 1989, & JP-A-01 196116 (MITSUI TOATSU CHEM. INC.) 07 August 1989,
- PATENT ABSTRACTS OF JAPAN vol. 10, no. 248 (E-431) 26 August 1986, & JP-A-61 078119 (SONY CORP.) 21 April 1986,
- IEEE ELECTRON DEVICE LETTERS. vol. 11, no. 6, June 1990, NEW YORK US pages 258 - 260; HIROSHI KANOH et al.: "Amorphous-Silicon/Silicon-Nitride Thin-Film Transistors fabricated by plasma-free (Chemical Vapor Deposition) method"
- PATENT ABSTRACTS OF JAPAN vol. 11, no. 209 (E-521) 07 July 1987, & JP-A-62 030314 (SONY CORP.) 09 February 1987,
- CZUBATYJ W. ET AL: 'Low-Temperature Polycrystalline-Silicon TFT on 7059 Glass' IEEE ELECTRON DEVICE LETTERS vol. 10, no. 8, August 1989, NEW YORK, US, pages 349 - 351
- LEMONS R.A. ET AL: 'Laser crystallization of Si films on glass' APPLIED PHYSICS LETTERS vol. 40, no. 6, 15 March 1982, pages 469 - 471

## Description

The present invention relates to a method for manufacturing a semiconductor device.

A technique of forming a non-single crystal semiconductor layer on a glass substrate by reduced pressure CVD or plasma CVD followed by heating the substrate at about 600°C thereby to crystallize the layer into a polycrystal semiconductor layer is well known in the field of manufacture of semiconductor devices. In this process of thermal crystallization, firstly the temperature is raised from room temperature (i.e. the initial stage), secondly the temperature is maintained at about 600°C (i.e. the intermediate stage) for from a few hours to several tens hours and finally the temperature is lowered to room temperature (i.e. the last stage). If a cheap glass substrate utilized for a large liquid crystal display device or the like is subjected to the thermal crystallization process at about 600°C, since a cheap glass substrate has its strain point at about 600°C, the glass substrate shrinks (that is, the volume of the glass at the last stage is smaller than than at the initial stage) and thereby causes internal stress in a semiconductor layer provided on the substrate. Further, the photolithography pattern to be used in the subsequent process is deformed due to the shrinkage of the glass substrate, so that mask alignment in the subsequent process becomes difficult to carry out. Experiments indicate that the interface state in the semiconductor layer formed on the substrate was high due to the internal stress, and therefore the electrical properties of the semiconductor layer were degraded. For the above reason, a technique for obtaining on a glass substrate a semiconductor layer having excellent electrical properties is required in the field of manufacture of semiconductor devices.

It would therefore be desirable to provide a semiconductor device of high performance and a method for manufacturing such a semiconductor device, and also to provide a semiconductor device comprising a channel region of high field effect mobility.

The abstract of JP-A-58182243 describes the preparation of a semiconductor device, in which the surface of a glass plate is processed with SiC₄ or TiC₄ gas and heated. Thereafter, one or more layers of Si₃N₄ thin films are formed and a poly-Si film is deposited.

The abstract of JP-A-63240524 describes a liquid crystal display element comprising a large glass substrate which is subjected to a preliminary calcination, and a small glass substrate constituting a liquid crystal cell.

In IEEE Electron Device Letters, Vol. 10, No. 8, August 1989, pp. 349-351, a polycrystalline-silicon thin-film transistor (TFT) deposited at low temperature on 7059 glass is described. In the described fabrication process, the problems associated with densification are addressed by a procedure in which densification is accomplished during the poly-Si recrystallization process.

In Applied Phys. Letters, Vol. 40, No. 6, 15 March 1982, pp. 469-471, laser crystallization of Si films on glass is described. By using glass substrates which approximate the thermal expansion of a deposited Si film, thermal stress cracking during laser crystallisation is eliminated. Chemical vapour deposition is used to coat these substrates first with a buffer layer of SiO₂ or Si₃N₄ and then with a Si film.

According to the invention there is provided a method for manufacturing a semiconductor device, the method comprising providing a glass substrate forming a silicon compound layer on said glass substrate; forming a non-single crystal semiconductor layer on a silicon compound layer; and crystallizing said non-single crystal semiconductor layer by heating; said silicon compound layer acting as a blocking layer for preventing alkali ions in said glass substrate from entering said non-single crystal semiconductor layer; characterized by heating said glass substrate for a predetermined time period at a predetermined temperature not higher than the strain point of the glass substrate before the non-single crystal semiconductor layer forming step and after the silicon compound layer forming step; and in that said time period and predetermined temperature are selected for preshrinking the glass substrate whereby shrinkage during the crystallizing of the non-single-crystal semiconductor layer is decreased.

In accordance with an embodiment of the invention, a glass substrate on which a silicon compound layer has been formed is first heated in a non-oxidizing atmosphere or an inactive gas atmosphere at a temperature not higher than the strain point of the glass substrate, a non-single crystal semiconductor layer is then formed on the substrate, and the non-single crystal semiconductor layer is crystallized by heat in a non-oxidizing atmosphere or an inactive gas atmosphere. The volume of the glass substrate at a given temperature, e.g. room temperature, after the glass substrate heating process is smaller than that at the same temperature before the glass substrate heating process. That is, the glass substrate shrinks after being heated. By virtue of this glass substrate heating process, when the non-single crystal semiconductor layer formed on the glass substrate is crystallized by heat, the volume of the glass substrate is decreased by a smaller amount, that is, the glass substrate shrinks very little. A crystallized semiconductor layer which is free from internal stress can therefore be obtained by the crystallization process.

The term "non-single crystal semiconductor" includes an amorphous semiconductor, a semi-amorphous semiconductor, a microcrystal semiconductor, and an imperfect polycrystal semiconductor. A microcrystal semiconductor is defined as a semiconductor in an amorphous state in which the crystal state is dispersed. On the other hand, an imperfect polycrystal semiconductor is defined as a semiconductor in a polycrystal state in which the crystal growth is imperfect, that is, crystals can be grown more.

The strain point of glass is defined as the temperature at which the viscosity of glass v is 4x10¹⁴ poise (log(v)=14.5)

Examples illustrating some features of the present invention will now be described, by way of example only, with reference to the accompanying drawings wherein:
Fig. 1 is a graph showing the relationship between shrinking percentage of a glass substrate and temperature;
Fig. 2 is a graph showing the relationship between shrinking percentage of a glass substrate and period of heating;
Fig. 3 is a graph showing relative intensity in laser Raman spectroscopic analysis for semiconductor layers;
Figs. 4(A) through (E) are schematic cross-sectional views showing a method for manufacturing a thin-film transistor in accordance with an example out of the scope of the present invention;
Fig. 5 is a graph showing the drain current - gate voltage characteristic of a thin-film transistor;
Fig. 6 is a graph showing the relationship between gate voltage and field effect mobility in a thin-film transistor;
Fig. 7 is a graph showing field effect mobility of a thin-film transistor;
Fig. 8 is another graph showing the relationship between shrinking percentage of a glass substrate and temperature;
Fig. 9 is another graph showing the relationship between shrinking percentage of a glass substrate and period of heating;
Fig. 10 is another graph showing relative intensity in laser Raman spectroscopic analysis for semiconductor layers;
Fig. 11 is still another graph showing relative intensity in laser Raman spectroscopic analysis for semiconductor layers;
Figs. 12(A) through (E) are schematic cross-sectional views showing a method for manufacturing a thin-film transistor in accordance with another example out of the scope of the present invention;
Fig. 13 is another graph showing drain current - gate voltage characteristic in a thin-film transistor;
Fig. 14 is another graphical view showing the relationship between gate voltage and field effect mobility in a thin-film transistor;
Fig. 15 is still another graph showing the drain current - gate voltage characteristic in a thin-film transistor;
Figs. 16(A) through (E) are schematic cross-sectional views showing a method for manufacturing a thin-film transistor in accordance with another example out of the scope of the present invention;
Fig. 17 is a further graph showing drain current - gate voltage characteristic in a thin-film transistor;
Fig. 18 is still another graph showing the relationship between gate voltage and field effect mobility in a thin-film transistor;
Fig. 19 is another graph showing field effect mobility of a thin-film transistor; and
Fig. 20 is a still further graph showing the drain current - gate voltage characteristic in a thin-film transistor.

In the following, examples are disclosed with, a blocking layer formed on a heated substrate. However, in the present invention a semiconductor device is manufactured by forming a blocking layer on a glass substrate followed by heating for preshrinting the glass substrate provided with the blocking layer.

The formation of a semiconductor layer on a substrate in accordance with a first example of a method out of the scope of the claims of the present invention will now be described. The substrate used in the first example is AN-2 non-alkali glass produced by Asahi Glass Company, whose strain point is 616°C. AN-2 non-alkali glass comprises SiO₂ (53%), Al₂O₃ (11%), B₂O₃ (12%), RO (24%), and R₂O (0.1%). The glass substrate is heated at 610°C for 12 hours in an electrical furnace. This glass substrate heating is carried out in an inactive gas atmosphere, e.g. N₂, under atmospheric pressure.

After the heating, a silicon compound layer, e.g. SiO₂ layer, 200nm thick is formed by sputtering in order to provide a blocking layer for preventing alkali ions residing in the glass substrate from entering a device to be formed on the substrate. An amorphous silicon layer 100nm thick is then formed thereon. The amorphous silicon layer is then heated at 600°C for 96 hours in an electrical furnace thereby to be crystallized. The crystallization is carried out in an inactive gas atmosphere, e.g. N₂, under atmospheric pressure, in order to prevent the amorphous silicon layer from reacting with a gas, e.g. oxygen.

The relationship between shrinking percentages and temperatures is now considered.

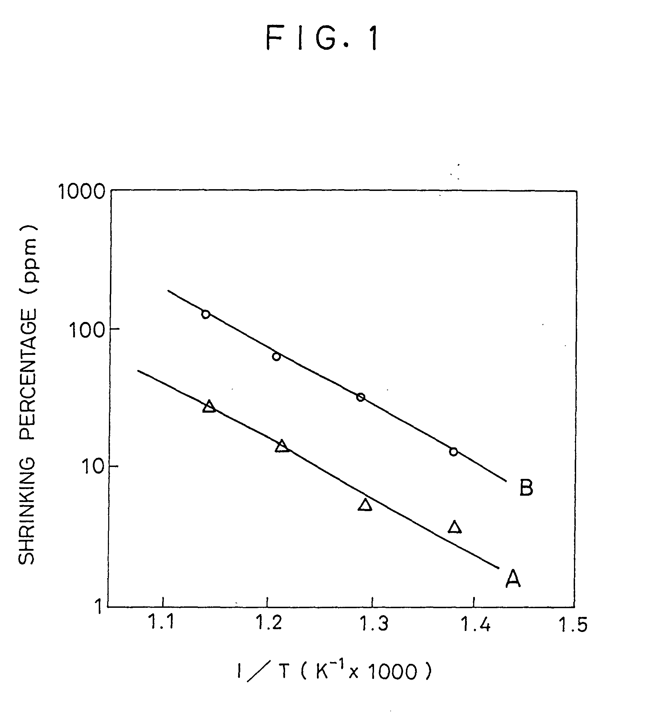

Glass substrates A (AN-2 non-alkali glass) which had been heated in advance in the same manner as in the first example were prepared. Also, glass substrates B (AN-2 non-alkali glass) which had never been heated were prepared. First, the volume of each substrate was measured at room temperature (the volume obtained is referred to as V₁). These glass substrates were then heated at various temperatures for 12 hours. After the heating process, the volume of each substrate was measured again at room temperature (the volume obtained is referred to as V₂). Then, the shrinking percentage of each substrate was calculated using the volume V₁ and the volume V₂ of each substrate. The relationship between the shrinking percentages of the heated glass substrates A and the temperatures is shown by line A in Fig. 1, while that in the case of the glass substrates B is shown by line B. As is apparent from Fig. 1, the shrinking percentages of the glass substrates A heated in advance are 1/5 or less of those of the glass substrates B. It is also found that the shrinking percentage tends to increase exponentially with the increase of the temperature. When manufacturing a thin-film transistor, since the shrinkage of previously heated glass substrates after the crystallization process is 1/5 or less compared with the shrinkage of non-heated glass substrates after the crystallization process, the error in mask alignment in the subsequent photolithography process in the case of the previously heated glass substrates becomes 1/5 or less compared with that in the case of the non-heated glass substrates. Therefore, it becomes possible to manufacture a large thin-film transistor by a one-step process.

Next, the relationship between shrinking percentages and periods of heating process is considered.

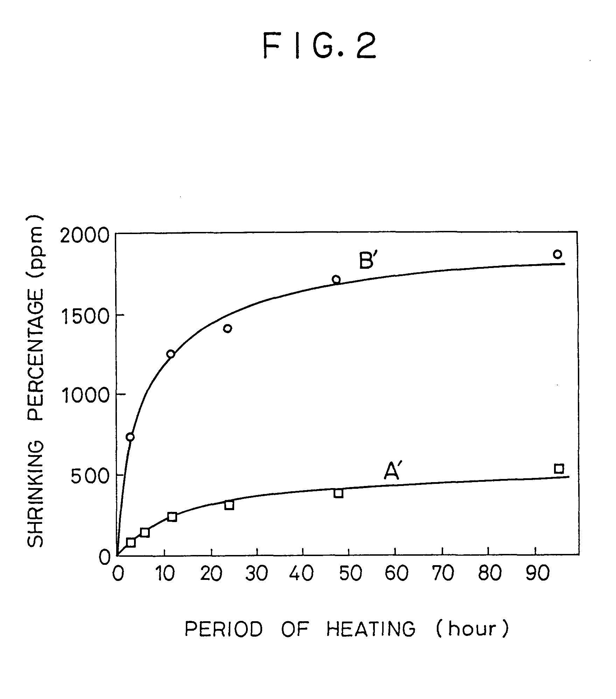

Glass substrates A' (AN-2 non-alkali glass) which had been heated in advance in the same manner as in the first example and glass substrates B' (AN-2 non-alkali glass) which had never been heated were prepared. First, the volume of each substrate was measured at room temperature (the volume obtained is referred to as V₁). These glass substrates were then heated at 600°C for various periods of time. After the heating process, the volume of each substrate was measured again at room temperature (the volume obtained is referred to as V₂). Then, the shrinking percentage of each substrate was calculated using the volume V₁ and the volume V₂ of each substrate. The relationship between the shrinking percentages of the heated glass substrates A' and the periods of heating is shown by curve A' in Fig. 2, while that in the case of the glass substrates B' is shown by curve B'. As is apparent from Fig. 2, the glass substrates shrink within the first several hours of the heating process, and the curves A' and B' have a tendency to be saturated with the passage of the time of heating. In the case of heating for 96 hours, the shrinkage of the glass substrate B' is about 2000ppm, while that of the glass substrate A' is only about 500ppm. It is obvious from Figs. 1 and 2 that, when manufacturing a thin-film transistor, the shrinkage of a glass substrate after crystallization process can be decreased by heating a glass substrate in advance.

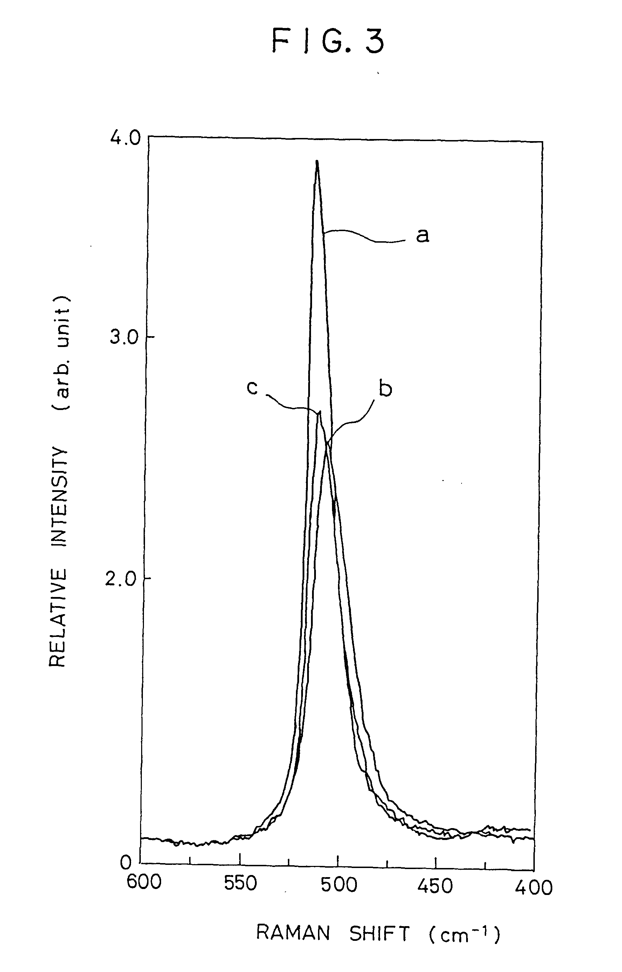

Fig. 3 shows relative intensity in Raman spectroscopic analysis for semiconductor layers. In the figure, curve a indicates that for a silicon semiconductor layer (a) crystallized in accordance with the first example. Curve b indicates that for a semiconductor layer (b) which was formed in the same manner as in the first example, except that a glass substrate (AN-2 non-alkali glass) which had never been heated was utilized instead of the previously heated glass substrate. Also, curve c indicates that for a semiconductor layer (c) which was formed in the same manner as in the first example, except that a quartz substrate was utilized instead of the previously heated AN-2 non-alkali glass substrate. The ordinate in Fig. 3 shows the relative strength of crystallinity of semiconductor layers. As is apparent from Fig. 3, the crystallinity of the silicon semiconductor layer (a) obtained in accordance with the first embodiment is far stronger than that of the semiconductor layers (b) and (c). The semiconductor layers (a) and (c) show sharp peaks at the same wavenumber respectively, and the location of these sharp peaks is peculiar to polycrystal silicon. Accordingly, the semiconductor layer (c) formed on the quartz substrate as well as the semiconductor layer (a) formed in accordance with the first example is a polycrystal of high crystallinity. In the silicon semiconductor layer (a), the internal stress generated by the crystallization process is very small by virtue of the previous heating of the glass substrate. As in the foregoing description, the previous heating of a glass substrate at a temperature not higher than strain point of the glass substrate is advantageous: the shrinkage of a glass substrate after the crystallization process is very small, and the internal stress generated in a crystallized semiconductor layer is also very small, whereby the crystallinity and electrical properties are improved.

With respect to the semiconductor layer (b), a sharp peak appears at a location slightly different from that peculiar to polycrystal silicon, as shown in Fig. 3. This is because the properties of the semiconductor layer (b) were affected by internal stress generated therein.

The activation energy for the AN-2 non-alkali glass is about 0.08eV, which is equivalent to a transition point of the glass (668°C). The activation energy is calculated using the formula indicating the straight line in Fig. 1, R = A exp (-Eₐ/kT) where A is a proportionality constant, Eₐ is the activation energy, and k is Boltzmann's constant.

The glass substrate heating may be carried out under reduced pressure, instead of atmospheric pressure.

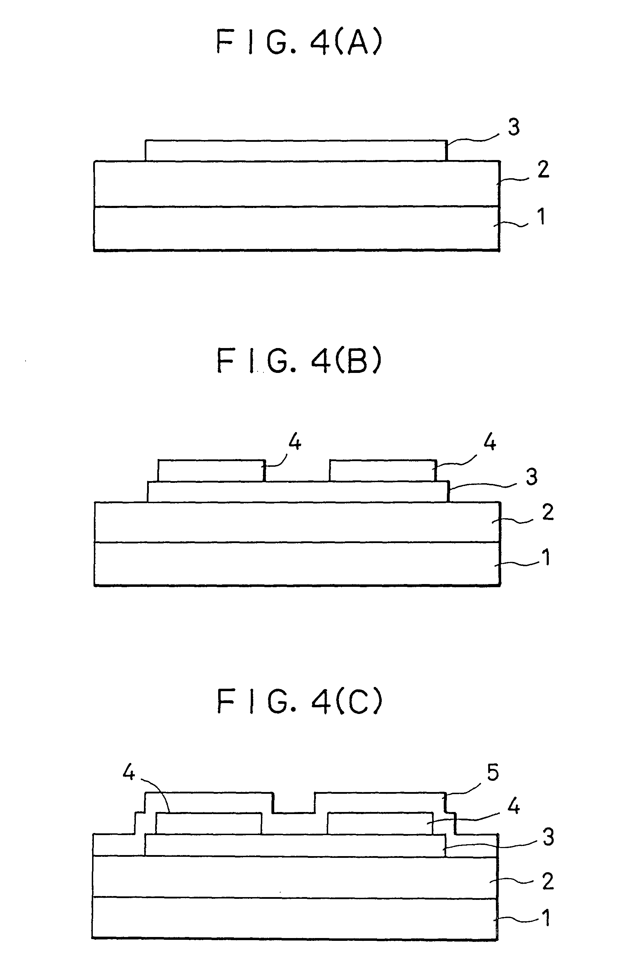

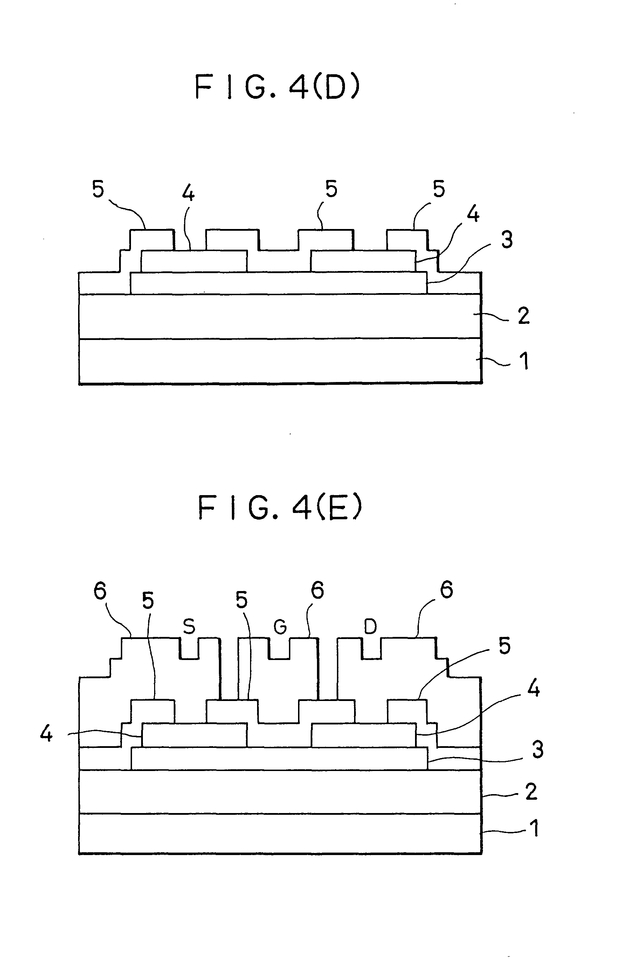

Referring now to Figs. 4 (A) through 4 (E), the manufacture of a polycrystal silicon thin-film transistor will be described in accordance with a second example.

A glass substrate (AN-2 non-alkali glass) 1 is heated at 610°C for 12 hours in an electrical furnace. This heating is carried out in an inactive gas atmosphere, e.g. N₂, under atmospheric pressure. It may alternatively be carried out in an inactive gas atmosphere involving an additive of hydrogen under atmospheric pressure or reduced pressure.

On the glass substrate 1, a silicon compound layer 2, e.g. SiO₂ layer, 200nm thick is formed by RF sputtering. This is carried out at a pressure of 0.5Pa, a temperature of 100°C. an RF frequency of 13.56MHz and an RF output power of 400W.

An amorphous silicon activation layer 3 100nm thick is then formed on the silicon compound layer by RF sputtering. This is carried out at a pressure of 0.5Pa, a temperature of 150°C, an RF frequency of RF of 13.56MHz and an RF output power of 400W.

The amorphous silicon layer 3 is then crystallized by heating to between 400°C and 800°C, preferably 500°C to 700°C, e.g. 600°C, for 96 hours in an inactive gas atmosphere,e.g. N₂, at atmospheric pressure. This crystallization process may alternatively be carried out under a high vacuum.

The crystallized silicon layer 3 is partially removed so that the pattern shown in Fig. 4 (A) is obtained.

Subsequently, an n⁺-type amorphous silicon layer 4 50nm thick is formed by PCVD at a pressure of 6.65Pa, a temperature of 350°C, an RF frequency of 13.56MHz and an RF output power of 400W at the ratio of PH₃ (5%) : SiH₄ : H₂ = 0.2 SCCM : 0.3 SCCM : 50 SCCM. The silicon layer 4 is then partially removed so that a gate region is formed as shown in Fig. 4(B).

A gate oxide film (Si0₂) 5 100 nm thick is formed by sputtering as shown in Fig. 4(C), at a pressure of 0.5Pa, a temperature of 100°C, an RF frequency of 13.56MHz and an RF output power of 400W. The gate oxide film 5 is then partially removed thereby to form contact holes as shown in Fig. 4(D).

Finally, an aluminum layer 300nm thick is formed by vacuum deposition and then patterned into electrodes 6, so as to form a polycrystal silicon thin-film transistor (a) as shown in Fig. 4(E). In Fig. 4(E), S indicates a source electrode, G a gate electrode and D a drain electrode.

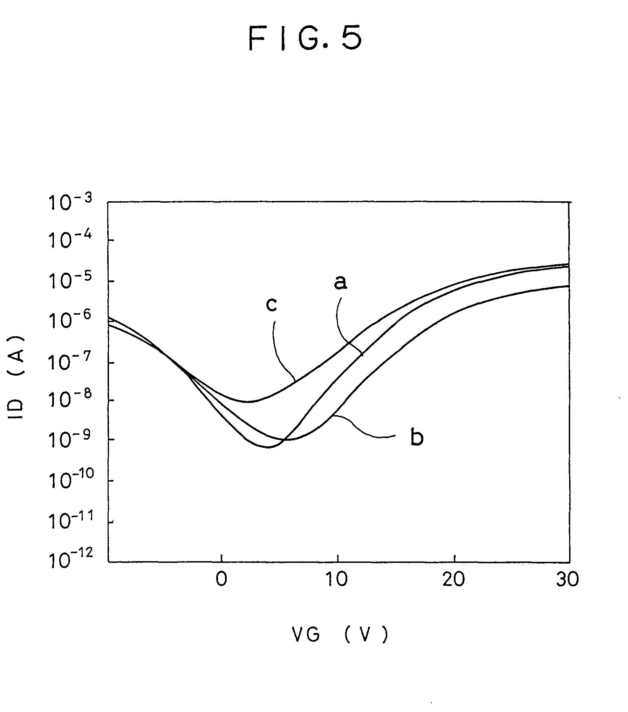

For comparison, another polycrystal silicon thin-film transistor (b) was manufactured in the same manner as in the second example, except that an AN-2 non-alkali glass substrate which has not been heated was utilized instead of the previously heated AN-2 non-alkali glass substrate. Also, a polycrystal silicon thin-film transistor (c) was manufactured in the same manner as in the second example except that a quartz substrate was utilized instead of the previously heated AN-2 non-alkali glass substrate. The I_{D} (drain current) - V_{G} (gate voltage) characteristics of thin-film transistors (a), (b) and (c) are indicated by curves a, b and c in Fig. 5. It is apparent from Fig. 5 that the I_{D}-V_{G} characteristic of the thin-film transistor (a) is improved considerably in comparison to that of the thin-film transistor (b), and also the electrical properties of the transistor (a) are close to that of the thin-film transistor (c).

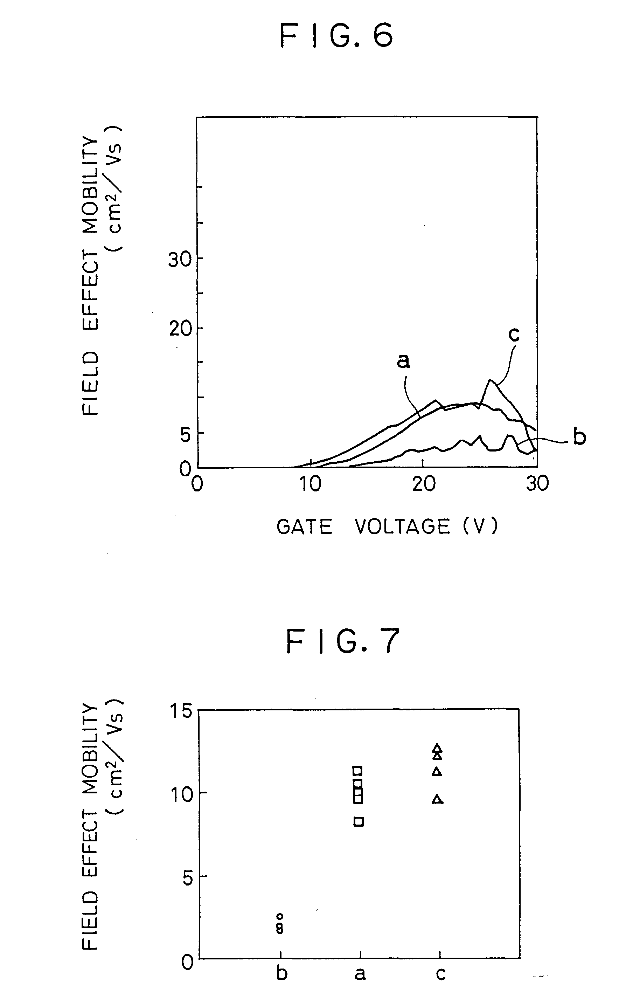

The relationship between gate voltage and field-effect mobility of the thin-film transistors (a), (b) and (c) is illustrated in Fig. 6. Fig. 7 shows field-effect mobilities, where a indicates a thin-film transistor manufactured in accordance with the second example, b indicates a thin-film transistor manufactured in the same manner as that of the above thin-film transistor (b), and c indicates a thin-film transistor manufactured in the same manner as that of the above thin-film transistor (c). It is found in Figs. 6 and 7 that the field-effect mobility of the thin-film transistor a is larger than that of the thin-film transistor b and is almost the same as that of the thin-film transistor c.

In accordance with a third example, the formation of a semiconductor layer on a substrate will now be described.

An AN-2 non-alkali glass whose strain point is 616°C, is utilized as a substrate. This glass substrate is heated at 610°C for 12 hours in an electrical furnace. This heating is carried out in an inactive gas atmosphere, e.g. N₂, involving hydrogen at 50% under atmospheric pressure. A silicon compound layer, e.g. Si0₂ layer, 200nm thick is then formed by magnetron RF sputtering, and subsequently an amorphous silicon layer 100nm thick is formed thereon by means of a magnetron RF sputtering apparatus in an atmosphere of hydrogen at a partial pressure of 0.75mTorr and argon at a partial pressure of 3.00mTorr at an RF power of 400W, utilizing a target made of silicon. The amorphous silicon layer is then crystallized by heating at 600°C for 96 hours.

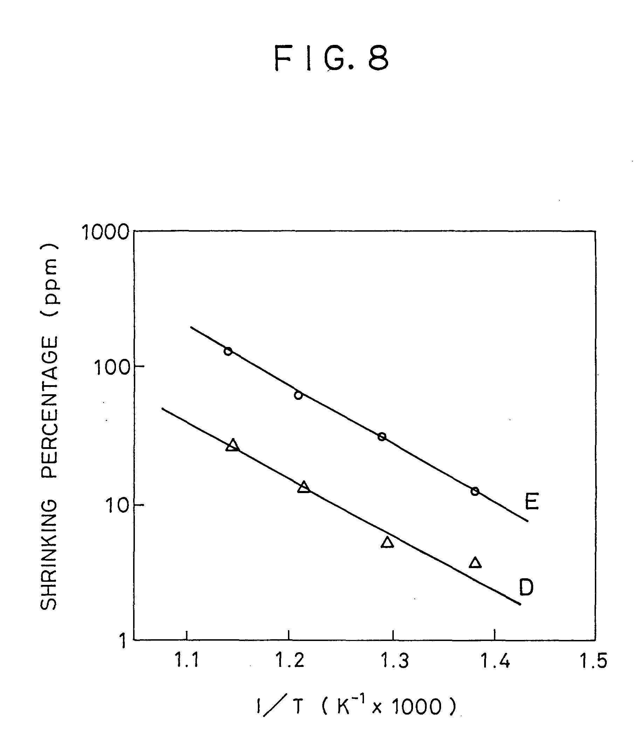

The shrinking percentages of glass substrates D which had been heated in advance in the same manner as in the third embodiment were measured. Those of glass substrates E which had not been heated were also measured. The relationship between shrinking percentages of the glass substrates D and E and temperatures is shown by lines D and E in Fig. 8 respectively. The shrinking percentage of each substrate in Fig. 8 was calculated in the same manner as in Fig. 1. As is apparent, the shrinking percentages of the heated glass substrates D were far lower than those of the non-heated glass substrates E.

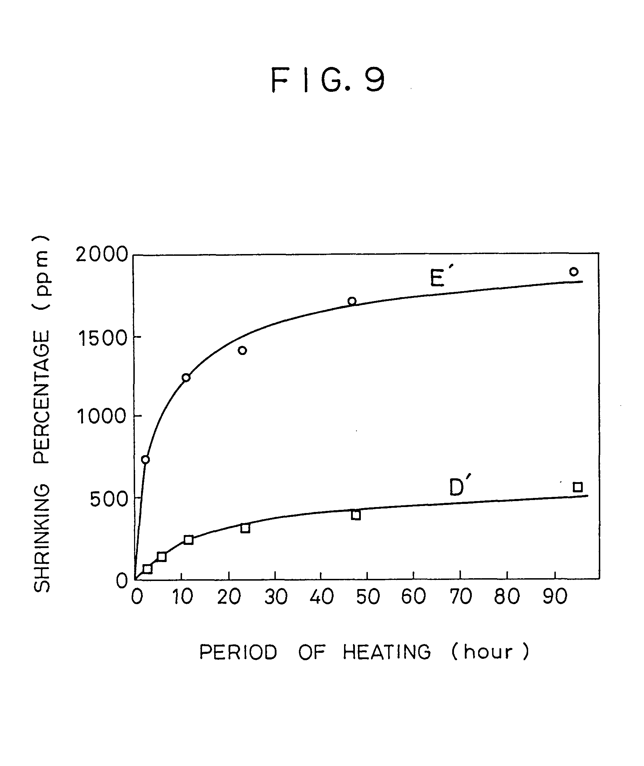

The relationship between the shrinking percentages and periods of heating is now considered. Glass substrates D' (AN-2 non-alkali glass) previously heated in the same manner as in the third example and glass substrates E' (AN-2 non-alkali glass) which had never been heated were heated at 600°C. The relationship between the shrinking percentages of the substrates D' and E' and the periods of heating is illustrated by curves D' and E' in Fig. 9. The shrinking percentage of each substrate in Fig. 9 was calculated in the same manner as in Fig. 2. The result is that, in the case of heating glass substrates for 96 hours, the shrinkage of the glass substrate E' was about 2000ppm, while that of the glass substrate D' was only about 500ppm.

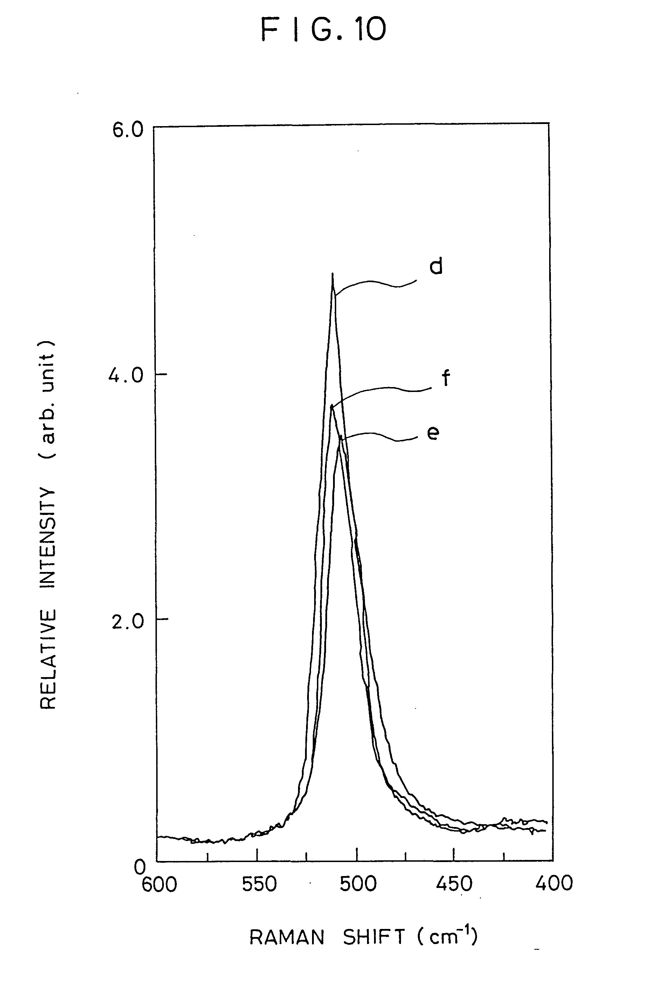

Fig. 10 shows relative intensity in Raman spectroscopic analysis for semiconductor layers. In the figure, curve d indicates that for a silicon semiconductor layer (d) crystallized in accordance with the third example. Also, curve e indicates that for a silicon semiconductor layer (e) which was formed in the same manner as in the third example, except that a non-heated AN-2 non-alkali glass substrate was utilized instead of the previously heated AN-2 non-alkali glass substrate and that an amorphous silicon layer was formed by plasma CVD instead of sputtering. Further, curve f indicates that for a silicon semiconductor layer (f) which was formed in the same manner as in the third example, except that a quartz substrate was utilized instead of the previously heated AN-2 non-alkali glass substrate and that an amorphous silicon layer was formed by plasma CVD instead of sputtering. The semiconductor layer (f) was polycrystal. The ordinate in Fig. 10 shows the relative strength of crystallinity of semiconductor layers. It is found from Fig. 10 that the crystallinity of the silicon semiconductor layer (d) in accordance with the third example is considerably higher than that of the semiconductor layers (e) and (f). The semiconductor layer (d) shows a sharp peak at the same wavenumber as that of the semiconductor layer (f). This means that the silicon semiconductor layer (d) in accordance with the third as well as the semiconductor layer (f) is a polycrystal of high crystallinity.

The semiconductor layer (e) showed a sharp peak at a location slightly different from that of polycrystal silicon, as shown in Fig. 10.

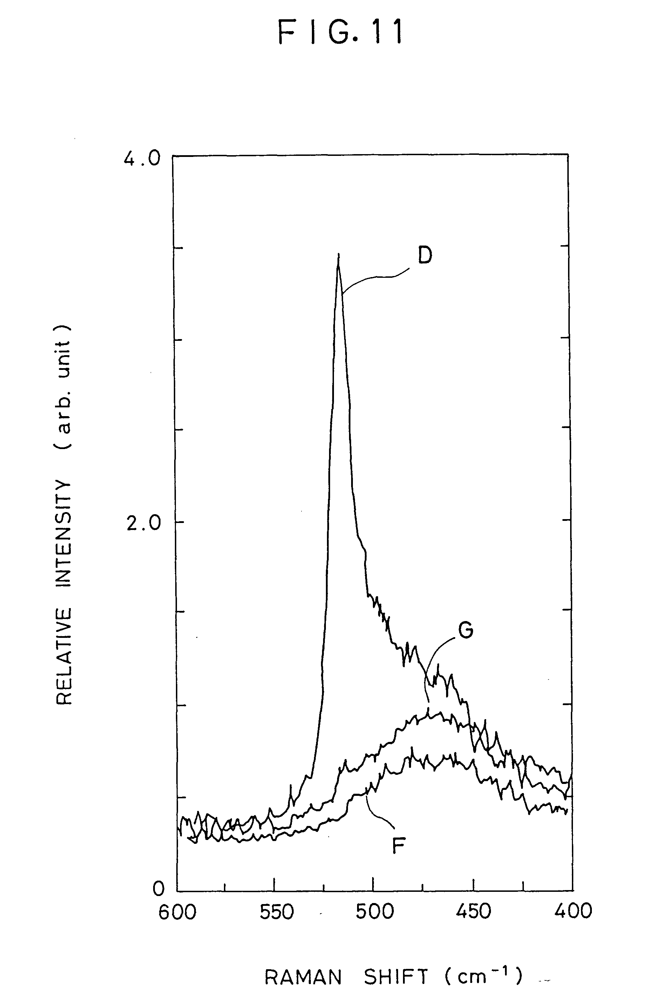

Fig. 11 shows relative intensity in Raman spectroscopic analysis for semiconductor layers. In the figure, curve D indicates that for a semiconductor layer (d) formed in accordance with the third example. Also, curve F indicates that for a semiconductor layer (F) which was formed in the same manner as in the third example, except that hydrogen was not introduced into a magnetron RF sputtering apparatus during formation of an amorphous silicon layer and that argon partial pressure was maintained at 3.75mTorr in the apparatus during the formation of the amorphous silicon layer. Further, curve G indicates that for a semiconductor layer (G) which was formed in the same manner as in the third example, except that the hydrogen partial pressure and the argon partial pressure were maintained at 0.15mTorr and 3.50mTorr respectively in a magnetron RF sputtering apparatus during formation of an amorphous silicon layer. With respect to the case of F where hydrogen was not introduced and the case of G where the hydrogen partial pressure was maintained at 0.15mTorr, they did not show sharp peaks at a wavenumber of 520cm⁻¹. On the other hand, the semiconductor layer (d) formed in accordance with the third example did show a sharp peak at a wavenumber of 520cm⁻¹, which means the semiconductor layer (d) is polycrystal. Thus, introducing hydrogen into a magnetron RF sputtering apparatus during sputtering is preferable. This is because, by introducing hydrogen during sputtering, a micro-structure is prevented from being formed in the semiconductor layer and crystallization can therefore be carried out with lower activation energy. In the case where hydrogen was introduced during sputtering, a semiconductor layer could be crystallized at 800°C or lower.

The glass substrate heating may be carried out under reduced pressure instead of atmospheric pressure.

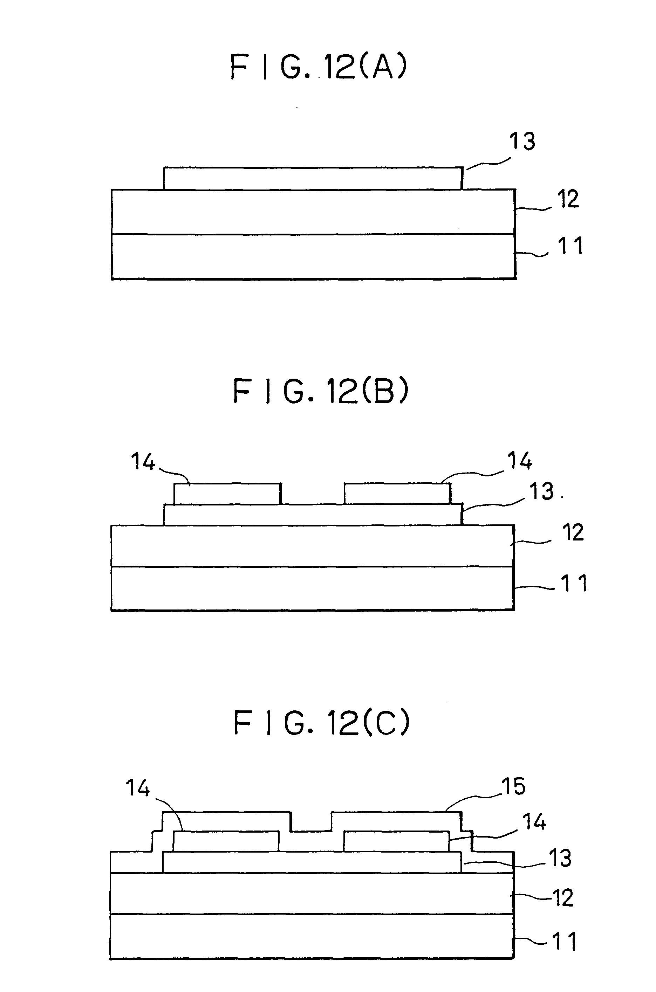

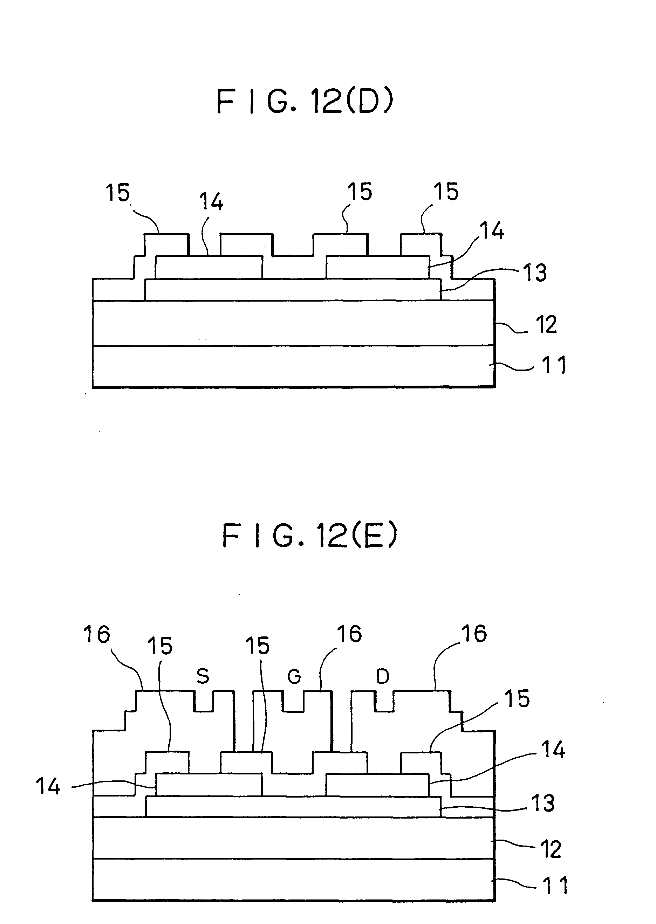

Referring next of Figs. 12(A) through 12(E), the manufacture of a polycrystal silicon thin-film transistor will be described in accordance with a fourth example.

A glass substrate 11 (AN-2 non-alkali glass) is cleaned by means of ultrasonic waves. The glass substrate 11 is then heated at 610°C for 12 hours. The glass substrate heating is carried out in an inactive gas atmosphere, e.g. N₂, including 50% hydrogen, at atmospheric pressure.

Then a silicon compound layer 12, e.g. SiO₂ layer, 200nm thick is formed on the glass substrate 11 by magnetron RF sputtering. The formation was carried out in an argon atmosphere at a pressure of 0.5Pa, a temperature of 100°C, an RF frequency of 13.56MHz and an RF output power of 400W.

An amorphous silicon activation layer 13 100nm thick is formed on the silicon compound layer formed by magnetron RF sputtering. The formation is carried out in an atmosphere of hydrogen at a partial pressure of 0.75Torr and argon at a partial pressure of 3.00Torr at a temperature of 150°C, an RF frequency of 13.56MHz and an RF output power of 400W.

Then the amorphous silicon layer 13 is crystallized by heat in an inactive gas atmosphere, e.g. N₂, under atmospheric pressure in an electrical furnace for 96 hours at a temperature of 400 to 800°C, preferably 500 to 700°C, e.g. 600°C. This crystallization process may be carried out in a hydrogen or carbon monoxide atmosphere or in an inactive gas atmosphere including hydrogen or carbon monoxide, in order to prevent the amorphous silicon layer from reacting with a gas, e.g. oxygen.

The crystallized silicon layer 13 is partially removed so that a pattern in Fig. 12(A) is obtained.

Subsequently, an N⁺-type amorphous silicon layer 14 50nm thick is formed on the silicon layer 13 by magnetron RF sputtering. The formation is carried out in an atmosphere of hydrogen at a partial pressure of 0.75Torr, argon at a partial pressure of 3.00Torr and PH₃ at a partial pressure of 0.05Torr at a temperature of 150°C, an RF frequency of 13.56Mhz and an RF output power of 400W. The silicon layer 14 is then partially removed to obtain a gate region as shown in Fig. 12(B). A gate oxide film (Si0₂) 15 100nm thick is then formed by magnetron RF sputtering at a pressure of 0.5Pa, a temperature of 100°C, an RF frequency of 13.56Mhz and an RF output power of 400W, as shown in Fig. 12(C).

The gate oxide film 15 is then partially removed thereby to form contact holes as shown in Fig. 12(D).

Finally, an aluminum layer 300nm thick is formed by vacuum deposition and then patterned into electrodes 16, so as to form a polycrystal silicon thin-film transistor shown in Fig. 12(E). In Fig. 12(E), S indicates a source electrode, G a gate electrode and D a drain electrode.

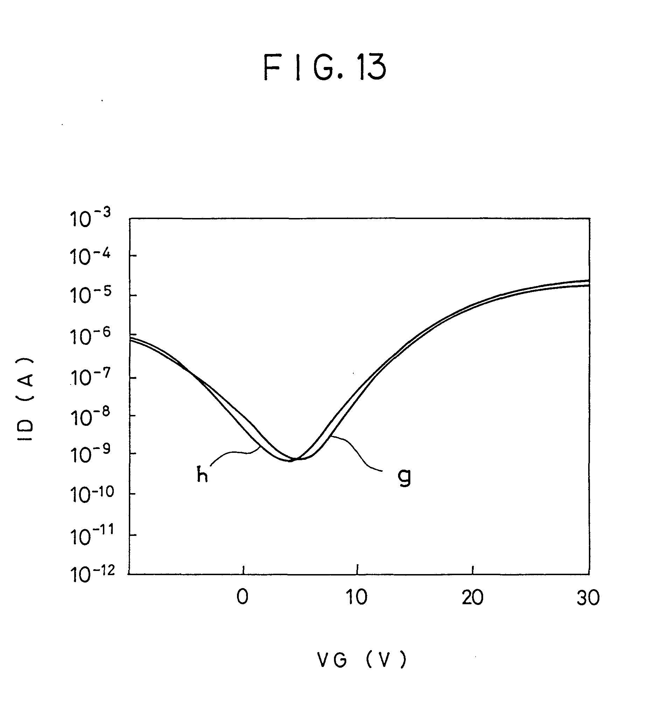

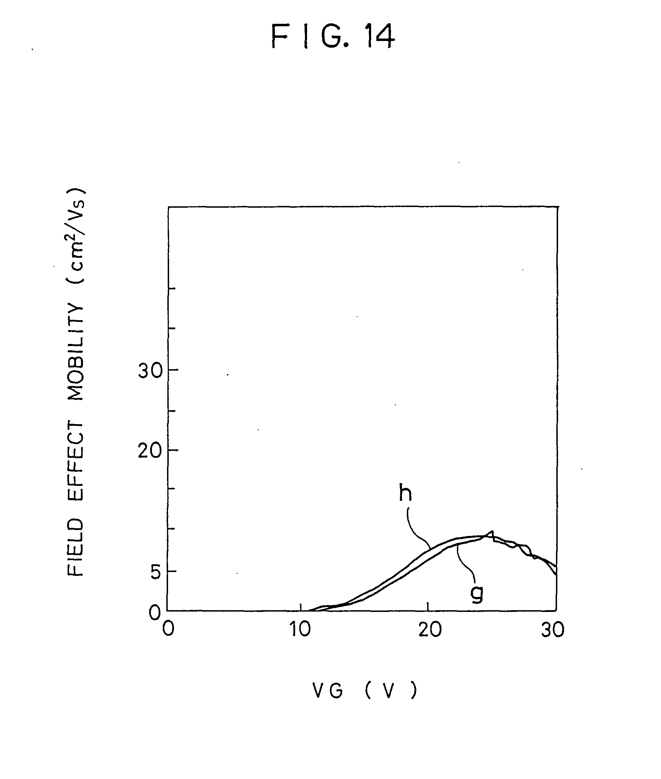

For comparison, a polycrystal silicon thin-film transistor (h) was manufactured in the same manner as in the fourth example, except that an amorphous silicon activation layer 13 was formed by plasma CVD instead of magnetron RF sputtering. In Fig. 13 the I_{D}-V_{G} characteristic of the thin-film transistor (h) is shown by curve h. Also, that of a thin-film transistor (g) in accordance with the fourth example is shown by curve g. As is apparent from Fig. 13, the I_{D}-V_{G} characteristics of the above two thin-film transistors are very close. Also, the relationship between gate voltage V_{G} and field-effect mobility µ with respect to the thin-film transistor (g) and that with respect to the thin-film transistor (h) are shown by curves g and H in Fig. 14 respectively. As is obvious from the figure, field-effect mobilities of the two thin-film transistors (g) and (h) are very close. From these results, it is recognised that the characteristics of the thin-film transistor (h) in which the amorphous silicon layer 13 is formed by plasma CVD are almost the same as those of the thin-film transistor (g) in accordance with the fourth example.

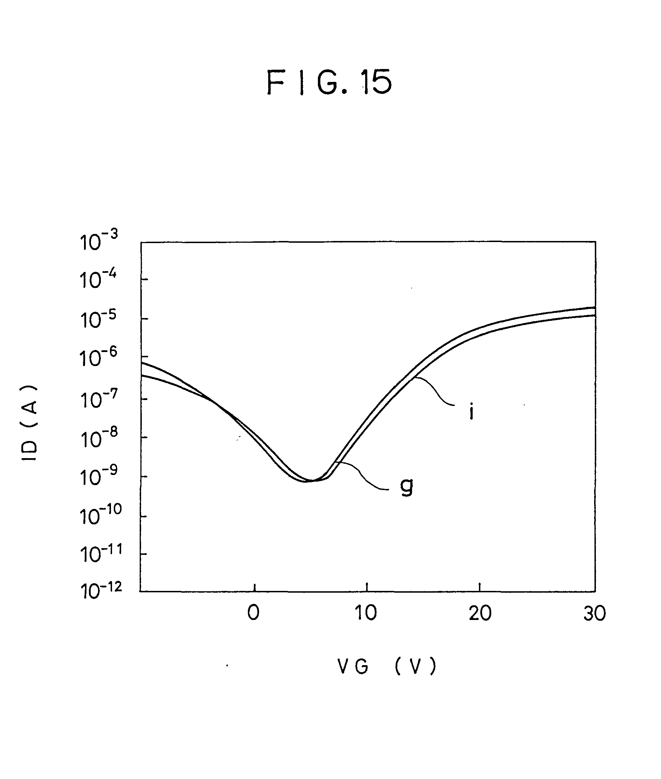

For a further comparison, a polycrystal silicon thin-film transistor (i) was manufactured in the same manner as in the fourth example, except that a glass substrate was heated in a nitrogen atmosphere to which hydrogen was not added. The I_{D}-V_{G} characteristic of the thin-film transistor (i) is shown by curve i in Fig. 15. That of the thin-film transistor (g) in accordance with the fourth example is shown by curve g. It is apparent from Fig. 15 that the characteristic of the thin-film transistor (g) is superior to that of the thin-film transistor (i). This is because the hydrogen etched oxygen residing on the glass substrate in the thin-film transistor (g), and accordingly the electrical properties of the thin-film transistor (g) were not degraded. In the fourth example, heating and cleaning of the glass substrate were carried out in one step. For reducing the number of manufacturing steps, it is preferred to heat a glass substrate in an inactive gas atmosphere involving hydrogen, as explained above. Carbon monoxide also functions to clean up oxygen on a glass substrate, so that the glass substrate heating may be carried out in an inactive gas atmosphere including carbon monoxide.

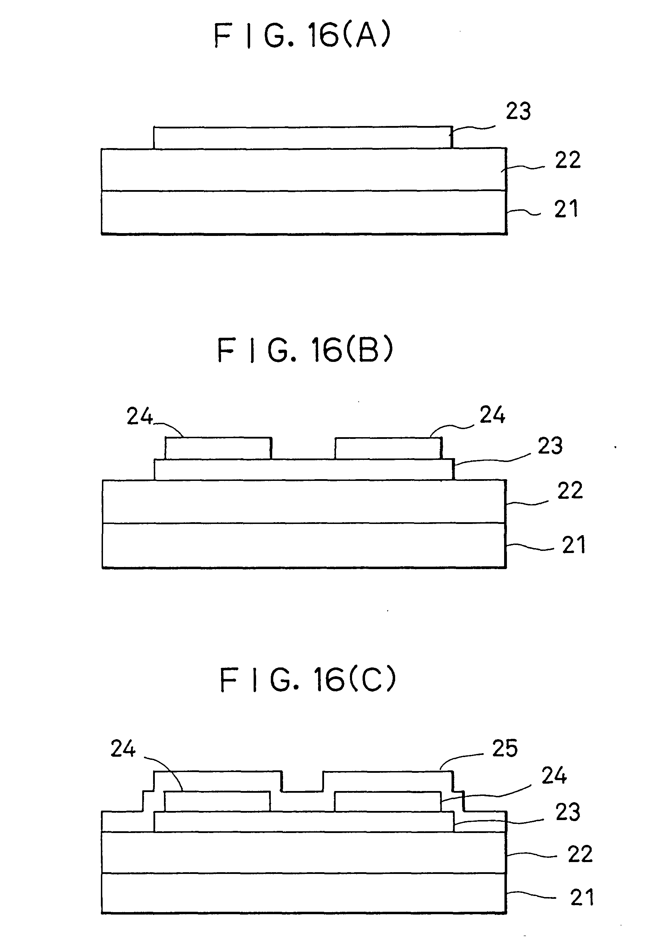

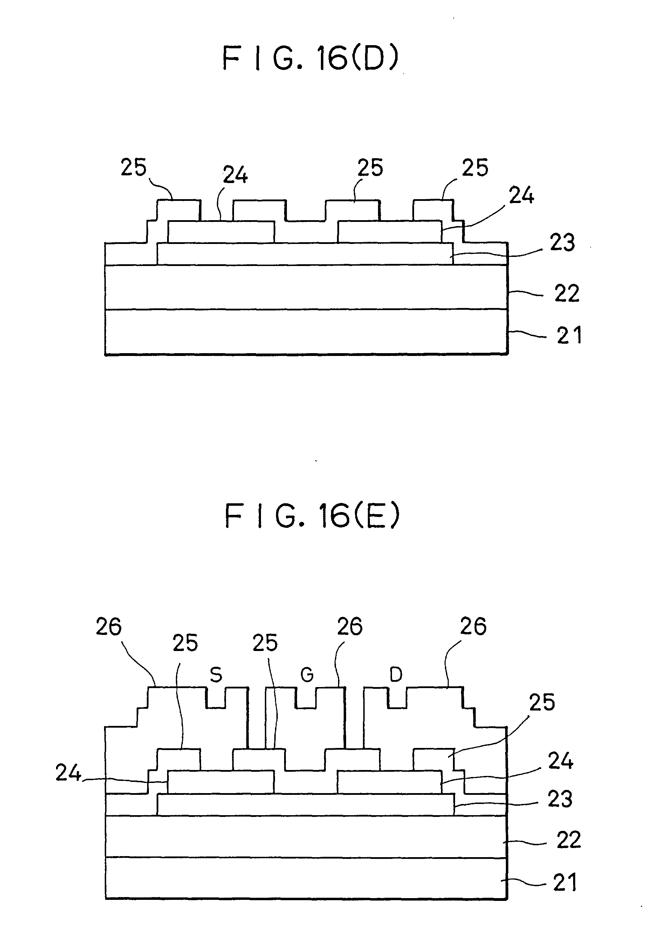

Referring next to Figs. 16(A) through 16(E), the manufacture of a polycrystal silicon thin-film transistor of coplanar type in accordance with a fifth example will now be described.

A glass substrate (An-2 non-alkali glass) 21 is heated at 610°C for 12 hours in an electrical furnace. This heating is carried out in an inactive gas atmosphere, e.g. N₂, under atmospheric pressure. The glass substrate heating may be carried out in a hydrogen or a carbon monoxide atmosphere or in an inactive gas atmosphere including hydrogen or carbon monoxide.

A silicon compound layer, e.g. Si0₂ layer, 22 200nm thick is formed by RF sputtering at a pressure of 0.5Pa, a temperature of 100°, an RF frequency of 13.56MHz and an RF output power of 400W.

On the silicon compound layer 22, an amorphous silicon activation layer 23 100nm thick is formed by RF sputtering at a pressure of 0.5Pa, a temperature of 150°C, an RF frequency of 13.56Mhz and an RF output power of 400W.

The amorphous silicon layer 23 is then crystallised by heating to a temperature of 400°C to 800°C, preferably 500°C to 700°C, e.g. 600°C, for 96 hours in a nitrogen atmosphere including 50% carbon monoxide. This crystallization is carried out in an electrical furnace under atmospheric pressure or reduced pressure. Since carbon monoxide combines with any oxygen residing on the glass substrate, the amorphous silicon layer 23 is not affected by oxygen. The crystallization process may be carried out by irradiating partially the silicon layer 23 with a laser so that the temperature of the silicon layer 23 is from 400°C to 800°C. In this case, at least a portion of the silicon layer 23 irradiated with the laser is crystallized to be utilized as a channel region.

The crystallized silicon layer 23 is then partially removed to form a pattern, as shown in Fig. 16(A). Reference numeral 23 in Fig. 16 designates a channel region formed from the crystallized silicon layer.

An n⁺-type amorphous silicon layer 24 50nm thick is formed by PCVD at a pressure of 6.65Pa, a temperature of 350°C, an RF frequency of 13.56MHz and an RF output power of 400W at a ratio of PH₃ (5%) : SiH₄ : H₂ = 0.2SCCM : 0.3SCCM : 50SCCM. The amorphous silicon layer 24 is partially removed to form a gate region as shown in Fig. 16(B).

A gate oxide film (Si0₂) 25 100nm thick is then formed by sputtering at a pressure of 0.5Pa, a temperature of 100°C, an RF frequency of 13.56Mhz and an RF output power of 400W as shown in Fig. 16(C). The gate oxide film 25 is then partially removed to form contact holes as shown in Fig. 16(D).

Finally, an aluminum layer 300nm thick is formed by vacuum deposition and then patterned into electrodes 26, so as to form polycrystal silicon thin-film transistor (j), as shown in Fig. 16(E). In Fig. 16(E), S is a source electrode, G a gate electrode and D a drain electrode.

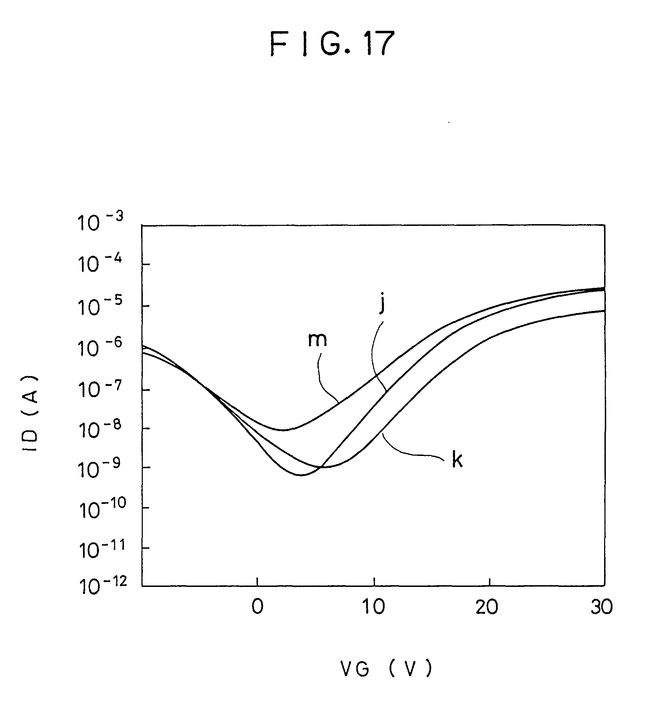

For comparison, a polycrystal silicon thin-film transistor (k) was manufactured in the same manner as in the fifth example, except that a non-heated glass substrate (AN-2 non-alkali glass) was utilized instead of the previously heated AN-2 non-alkali glass substrate. Also, a polycrystal silicon thin-film transistor (m) was manufactured in the same manner as in the fifth example, except that a quartz substrate was utilized instead of the previously heated AN-2 non-alkali glass substrate. The I_{D}-V_{G} characteristics of the thin-film transistors (j), (k) and (m) are shown by curves j, k and m in Fig. 17 respectively. It is found from the figure that the I_{D}-V_{G} characteristic of the thin-film transistor (j) in accordance with the fifth example is far superior to the thin-film transistor (k) utilizing a non-heated glass substrate. The electrical properties of the thin-film transistor (j) are close to those of the thin-film transistor (m) formed on a quartz substrate.

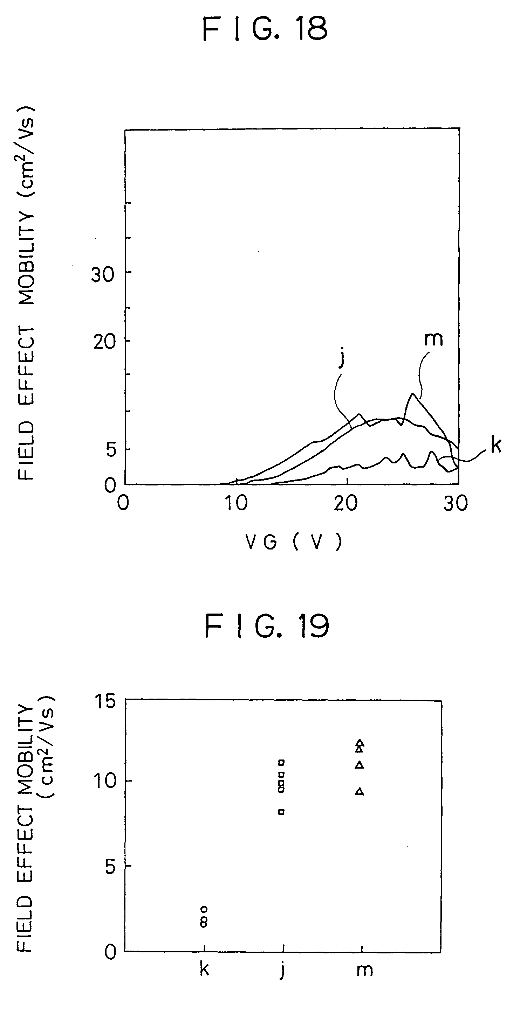

Fig. 18 shows the relationship between gate voltage V_{G} and field-effect mobility µ of the thin-film transistor (j), (k) and (m). Fig. 19 shows field-effect mobility µ, where j indicates a thin-film transistor manufactured in the same manner as that of the thin-film transistor (j), k indicates a thin-film transistor manufactured in the same manner as that of the thin-film transistor (k) and m indicates a thin-film transistor manufactured in the same manner as that of the thin-film transistor (m). As is apparent from Figs. 18 and 19, the field-effect mobilities µ of the thin-film transistors (j) in accordance with the fifth example are higher than those of the thin-film transistors (k) manufactured on non-heated AN-2 non-alkali glass substrates and are almost the same as those of the thin-film transistors (m) manufactured on quartz substrates.

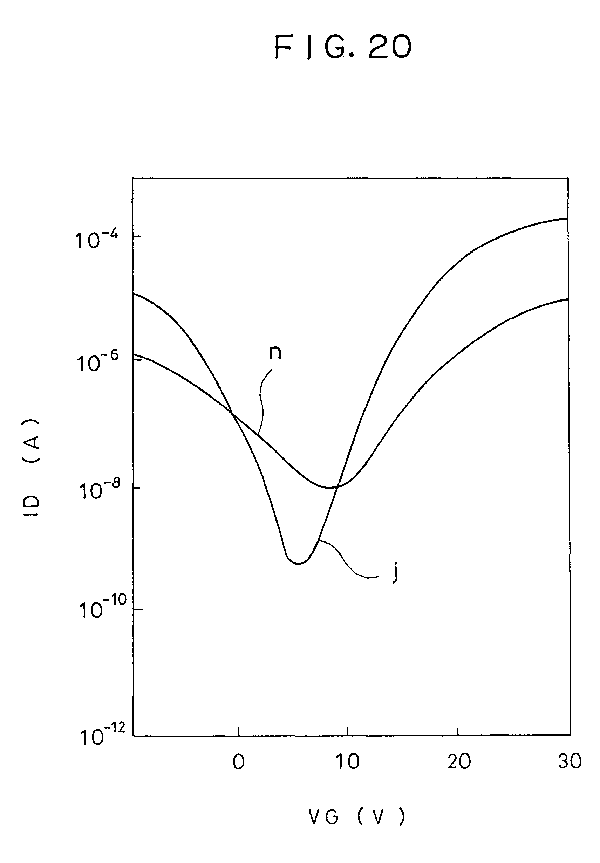

For a further comparison, thin-film transistors (n) were manufactured in the same manner as in the fifth example, except that the amorphous silicon layer 23 was crystallized in an atmosphere of 100% nitrogen instead of the nitrogen atmosphere including 50% carbon monoxide. In these thin-film transistors (n), a field-effect mobility exceeding 100 cm⁻²/Vₛ could not be obtained. On the contrary, with respect to the thin-film transistors manufactured in accordance with the fifth example, 10% or more of all the products had a field-effect mobility exceeding 120cm⁻²/Vₛ. In Fig. 20, the I_{D}-V_{G} characteristics of the thin-film transistors (j) and (n) are shown by curves j and n. As is apparent from Fig. 20, the thin-film transistor (j) manufactured in accordance with the fifth example is superior to the thin-film transistor (n).

It should be noted that the present invention includes various modifications and variations which could be made without falling outside the scope of the present invention as determined from the claims. For example, a non-single crystal semiconductor layer may be formed by chemical vapour deposition, vacuum deposition, ion cluster beam, MBE (molecular beam epitaxy), laser abrasion and the like. A polycrystal semiconductor layer of high crystallinity can be obtained from the non-single crystal semiconductor layer by the method of the present invention. Also, thin-film transistors of stagger type, inverse stagger type and inverse coplanar type may be manufactured by the method of the present invention. A glass substrate may be heated in a photo-CVD apparatus equipped with heating means, instead of an electrical furnace. In this case, hydrogen is introduced and activated in the photo-CVD apparatus during the heating, thereby to enhance the cleaning of a substrate surface.

Further, a silicon nitride layer, a silicon carbide layer, a silicon oxide layer, a silicon oxinitride layer or a multilayer comprising some of the above layers may be provided on a glass substrate as a blocking layer, in the present invention. By the provision of such a blocking layer, alkali ions residing in a glass substrate can be prevented from entering a device formed on the substrate.

Also, LE-30 comprising Si0₂ (60%), Al₂0₃ (15%), B₂0₃ (6%), and R₂0 (2%) manufactured by HOYA Corporation, TRC-5 comprising Si0₂, Al₂0₃, and ZnO manufactured by Ohara Inc., and N-O manufactured by Nippon Electric Glass Co., Ltd. may be used instead of AN-2 non-alkali glass.

## Claims

1. A method for manufacturing a semiconductor device, the method comprising the steps of:
providing a glass substrate (1,11,21);
forming a silicon compound layer (2,12,22) on said glass substrate (1,11,21);
forming a non-single crystal semiconductor layer (3,13,23) on a silicon compound layer (2,12,22); and
crystallizing said non-single crystal semiconductor layer (3,13,23) by heating;
said silicon compound layer (2,12,22) acting as a blocking layer for preventing alkali ions in said glass substrate (1,11,21) from entering said non-single crystal semiconductor layer (3,13,23);
**characterized by**
heating said glass substrate (1,11,21) for a predetermined time period at a predetermined temperature not higher than the strain point of the glass substrate (1,11,21) before the non-single crystal semiconductor layer forming step and after the silicon compound layer forming step; and in that said time period and predetermined temperature are selected for preshrinking the glass substrate whereby shrinkage during the crystallizing of the non-single-crystal semiconductor layer is decreased.

2. A method as claimed in claim 1, wherein the step of heating said glass substrate (1,11,21) is carried out in a non-oxidizing or inactive gas atmosphere.

3. A method as claimed in claim 1 or 2, wherein said silicon compound layer (2,12,22) comprises silicon oxide, silicon nitride, silicon carbide, or silicon oxinitride.

4. A method as claimed in any preceding claim, wherein said non-single crystal semiconductor layer (3,13,23) is formed by sputtering in an atmosphere comprising hydrogen gas and an inactive gas.

5. A method as claimed in claim 4, wherein said inactive gas comprises argon.

6. A method as claimed in any preceding claim, wherein said glass substrate heating step is carried out in an atmosphere comprising at least one of an inactive gas, nitrogen, hydrogen, and carbon monoxide.

7. A method as claimed in any preceding claim, wherein said crystallizing heating step is carried out in an atmosphere comprising at least one of an inactive gas, nitrogen, hydrogen, and carbon monoxide.

8. A method as claimed in any preceding claim, wherein said semiconductor layer (3,13,23) is crystallized at a temperature from 400°C to 800°C.

9. A method as claimed in any preceding claim, wherein the non-single crystal semiconductor layer (3,13,23) comprises amorphous silicon.

10. A method as claimed in claim 1, wherein the semiconductor device is a thin film transistor comprising a channel region formed by said non-single crystal semiconductor layer (3,13,23), and a gate electrode (G) adjacent to said channel region with a gate oxide film (5,15,25) between said channel region and said gate electrode (G).

11. A method as claimed in claim 1, wherein the semiconductor device is a thin film transistor of a coplanar type, inverse coplaner type, stagger type or inverse stagger type.

12. A method as claimed in claim 1, wherein said non-single crystal semiconductor layer (3,13,23) is formed by an amorphous silicon layer having a Raman spectroscopic analysis peak at the same wavenumber as a silicon film provided over a quartz substrate.

## Patentansprüche

1. Verfahren für das Herstellen eines Halbleitergeräts, wobei das Verfahren folgende Schritte umfasst:
Bereitstellen eines Glassubstrats (1, 11, 21),
Bilden einer Siliciumverbundschicht (2, 12, 22) auf dem Glassubstrat (1, 11, 21),
Bilden einer Nicht-Einkristall-Halbleiterschicht (3, 13, 23) auf einer Siliciumverbundschicht (2, 12, 22) und
Kristallisieren der Nicht-Einkristall-Halbleiterschicht (3, 13, 23) durch Erhitzen,
wobei die Siliciumverbundschicht (2, 12, 22) als Blockierungsschicht wirkt, um Alkaliionen in dem Glassubstrat (1, 11, 21) daran zu hindern, in die Nicht-Einkristall-Halbleiterschicht (3, 13, 23) einzudringen,
**gekennzeichnet durch**
Erhitzen des Glassubstrats (1, 11, 21) für eine vorbestimmte Zeitspanne bei einer vorbestimmten Temperatur, die nicht höher liegt als der Belastungspunkt des Glassubstrats (1, 11, 21) vor dem Schritt der Bildung der Nicht-Einkristall-Halbleiterschicht und nach dem Schritt der Bildung der Siliciumverbundschicht, und **dadurch**, dass die Zeitspanne und die vorbestimmte Temperatur für das Vorschrumpfen des Glassubstrats ausgewählt werden, wodurch das Schrumpfen während des Kristallisierens der Nicht-Einkristall-Halbleiterschicht reduziert wird.

2. Verfahren nach Anspruch 1, wobei der Schritt des Erhitzens des Glassubstrats (1, 11, 21) in einer nicht oxidierenden oder inaktiven Gasatmosphäre durchgeführt wird.

3. Verfahren nach Anspruch 1 oder 2, wobei die Siliciumverbundschicht (2, 12, 21) Siliziumoxid, Siliziumnitrid, Siliciumcarbid oder Siliciumoxynitrid umfasst.

4. Verfahren nach einem der vorhergehenden Ansprüche, wobei die Nicht-Einkristall-Halbleiterschicht (3, 13, 23) durch Kathodenzerstäubung in einer Atmosphäre gebildet wird, die Wasserstoffgas und ein inaktives Gas umfasst.

5. Verfahren nach Anspruch 4, wobei das inaktive Gas Argon umfasst.

6. Verfahren nach einem der vorhergehenden Ansprüche, wobei der Glassubstrat-Erhitzungsschritt in einer Atmosphäre durchgeführt wird, die mindestens eines unter einem inaktiven Gas, Stickstoff, Wasserstoff und Kohlenmonoxid umfasst.

7. Verfahren nach einem der vorhergehenden Ansprüche, wobei der Kristallisierungs-Erhitzungsschritt in einer Atmosphäre durchgeführt wird, die mindestens eines unter einem inaktiven Gas, Stickstoff, Wasserstoff und Kohlenmonoxid umfasst.

8. Verfahren nach einem der vorhergehenden Ansprüche, wobei die Halbleiterschicht (3, 13, 23) bei einer Temperatur von 400 °C bis 800 °C kristallisiert wird.

9. Verfahren nach einem der vorhergehenden Ansprüche, wobei die Nicht-Einkristall-Halbleiterschicht (3, 13, 23) amorphes Silicium umfasst.

10. Verfahren nach Anspruch 1, wobei das Halbleitergerät ein Dünnschichttransistor ist, der eine Kanalregion, die durch die Nicht-Einkristall-Halbkleiterschicht (3, 13, 23) gebildet wird und eine Gate-Elektrode (G) umfasst, die neben der Kanalregion liegt, wobei sich eine Gate-Oxidschicht (5, 15, 25) zwischen der Kanalregion und der Gate-Elektrode (G) befindet.

11. Verfahren nach Anspruch 1, wobei das Halbleitergerät ein Dünnschichttransistor eines koplanaren Typs, umgekehrt koplanaren Typs, gestaffelten Typs oder umgekehrt gestaffelten Typs ist.

12. Verfahren nach Anspruch 1, wobei die Nicht-Einkristall-Halbleiterschicht (3, 13, 23) durch eine amorphe Siliciumschicht gebildet wird, die einen Raman-Spektroskopieanalyse-Peak bei der gleichen Wellenzahl wie eine auf einem Quarzsubstrat bereitgestellte Siliciumschicht aufweist.

## Revendications

1. Procédé de fabrication d'un composant à semiconducteur, le procédé comprenant les étapes consistant à :
prévoir un substrat de verre (1, 11, 21) ;
former une couche d'un composé de silicium (2, 12, 22) sur ledit substrat de verre (1, 11, 21) ;
former une couche de semiconducteur non monocristallin (3, 13, 23) sur une couche d'un composé de silicium (2, 12, 22) ; et
cristalliser ladite couche de semiconducteur non monocristallin (3, 13, 23) par chauffage ;
ladite couche d'un composé de silicium (2, 12, 22) agissant comme une couche de blocage pour empêcher des ions alcali dans ledit substrat de verre (1, 11, 21) de pénétrer dans ladite couche de semiconducteur non monocristallin (3, 13, 23) ;
**caractérisé par**
le chauffage dudit substrat de verre (1, 11, 21) pendant une période de temps prédéterminée à une température prédéterminée non supérieure à la température inférieure de recuit du substrat de verre (1, 11, 21) avant l'étape de formation de la couche de semiconducteur non monocristallin et après l'étape de formation de la couche d'un composé de silicium ; et en ce que ladite période de temps et la température prédéterminée sont sélectionnées pour faire subir un pré-retrait au substrat de verre de sorte que le retrait pendant la cristallisation de la couche de semiconducteur non monocristallin est diminué.

2. Procédé selon la revendication 1, dans lequel l'étape de chauffage dudit substrat de verre (1, 11, 21) est effectuée dans une atmosphère de gaz inactif ou non oxydant.

3. Procédé selon la revendication 1 ou 2, dans lequel ladite couche d'un composé de silicium (2, 12, 22) comprend de l'oxyde de silicium, du nitrure de silicium, du carbure de silicium, ou de l'oxynitrure de silicium.

4. Procédé selon l'une quelconque des revendications précédentes, dans lequel ladite couche de semiconducteur non monocristallin (3, 13, 23) est formée par pulvérisation cathodique dans une atmosphère comprenant du gaz d'hydrogène et un gaz inactif.

5. Procédé selon la revendication 4, dans lequel ledit gaz inactif comprend de l'argon.

6. Procédé selon l'une quelconque des revendications précédentes, dans lequel ladite étape de chauffage du substrat de verre est effectuée dans une atmosphère comprenant au moins l'un d'un gaz inactif, de l'azote, de l'hydrogène et du monoxyde de carbone.

7. Procédé selon l'une quelconque des revendications précédentes, dans lequel ladite étape de chauffage de cristallisation est effectuée dans une atmosphère comprenant au moins l'un d'un gaz inactif, de l'azote, de l'hydrogène et du monoxyde de carbone.

8. Procédé selon l'une quelconque des revendications précédentes, dans lequel ladite couche de semiconducteur (3, 13, 23) est cristallisée à une température de 400 °C à 800 °C.

9. Procédé selon l'une quelconque des revendications précédentes, dans lequel la couche de semiconducteur non monocristallin (3, 13, 23) comprend du silicium amorphe.

10. Procédé selon la revendication 1, dans lequel le composant à semiconducteur est un transistor à couches minces comprenant une zone de canal formée par ladite couche de semiconducteur non monocristallin (3, 13, 23), et une électrode de grille (G) adjacente à ladite zone de canal avec un film d'oxyde de grille (5, 15, 25) entre ladite zone de canal et ladite électrode de grille (G).

11. Procédé selon la revendication 1, dans lequel le composant à semiconducteur est un transistor à couches minces du type coplanaire, du type coplanaire inverse, du type à décalage ou du type à décalage inverse.

12. Procédé selon la revendication 1, dans lequel ladite couche de semiconducteur non monocristallin (3, 13, 23) est formée par une couche de silicium amorphe ayant une crête d'analyse spectroscopique de Raman au même nombre d'onde qu'un film de silicium disposé sur un substrat de quartz.
